# EUROPEAN PATENT APPLICATION

(11) **EP 3 761 765 A1**
(43) Date of publication of application: **06.01.2021**
(21) Application number: 19767641.4
(22) Date of filing: 24.01.2019
(51) Int. Cl.: H05K 1/18

(54) **FPCB, SMART CARD AND PACKAGING METHOD THEREFOR**

(30) Priority: 12.03.2018 CN 201810199686
(71) Applicant: Shenzhen Excelsecu Data Technology Co., Ltd, Shenzhen, Guangdong 518000 (CN)
(72) Inventor: CHEN, Liuzhang, Shenzhen, Guangdong 518000 (CN)
(74) Representative: Sun, Yiming
(86) International application number: PCT/CN2019/072994
(87) International publication number: WO 2019/174412

(57) **Abstract**

Disclosed are an FPCB, a smart card, and a packaging method thereof. A first component (5) and a second component (6) are disposed on the FPCB (4), and a through groove (41) is disposed on the FPCB (4) in a position of the second component (6), where the through groove (41) is configured to enable the FPCB (4) to provide a deformation space when the second component (6) and the first component (5) are positioned on an upper substrate (1). The deformation is used to adjust a processing error between the two components, so as to position and fasten the two components on the FPCB (4), thereby avoiding a defective appearance or function caused by displacement of the two positions of the two components that is resulted from the production processing error, and further ensuring that components on the smart card (100) meet appearance and function requirements and increasing a production yield rate of the smart card (100).

## Description

### TECHNICAL FIELD

The present invention relates to the field of smart card technologies, and in particular, to an FPCB, a smart card, and a packaging method thereof.

### BACKGROUND

Currently, a produced smart card usually includes an electronic display screen and a carrier tape unit. Relative positions of the carrier tape unit and the display screen are fixed. If displacement occurs in the two positions, the entire card is scrapped due to impact on its appearance. However, in the actual production process, the carrier tape unit and the display screen may encounter a processing error, which causes displacement to the positions of the carrier tape unit and the display screen, and a failure in accurate positioning. Consequently, the appearance or functions are defective, and a smart card scrap rate is relatively high.

### TECHNICAL PROBLEM

A main objective of the present invention is to provide an FPCB, a smart card, and a packaging method thereof, so as to resolve a problem that displacement occurs in relative positions of at least two components of a smart card due to processing, and consequently the appearance or functions are defective and a scrap rate is relatively high.

### TECHNICAL SOLUTION

To achieve the foregoing objective, the present invention provides an FPCB, applied to a smart card, the smart card including an upper substrate, where a first component and a second component are disposed on the FPCB, and a through groove is disposed on the FPCB in a position of the second component, where the through groove is configured to enable the FPCB to provide a deformation space when the second component and the first component are positioned on the upper substrate.

Preferably, the through groove is disposed around the second component with the two ends disconnected.

Preferably, the second component is provided with a first side facing the first component, two second sides adjacent to the first side, and a third side opposite to the first side;
the through groove is disposed around the first side and the two second sides of the second component, so that a mounting area, for the second component, connected on the third side to the other part of the FPCB is formed on the FPCB, and the second component is disposed in the mounting area for the second component; and
the two ends of the through groove extend toward each other, so that the two ends of the through groove are located on the third side of the second component.

Preferably, the first component and the second component are components visible on a surface of the smart card.

Preferably, the first component is a display screen, and the second component is a carrier tape unit.

In addition, to achieve the foregoing objective, the present invention further provides a smart card, including:
the FPCB described above, where a first component and a second component are disposed on the FPCB, and a through groove is disposed on the FPCB in a position of the second component, where the through groove is configured to enable the FPCB to provide a deformation space when the second component and the first component are positioned an upper substrate;
an upper substrate, where a through hole for assembling and fastening the second component is disposed on the upper substrate;
a lower substrate, disposed below the upper substrate; and
a middle frame, sandwiched between the upper substrate and the lower substrate, configured to surround and form an interior receiving cavity jointly with the upper substrate and the lower substrate, where the interior receiving cavity is configured to accommodate the FPCB.

In addition, to achieve the foregoing objective, the present invention further provides a smart card packaging method, including the following steps:
providing an FPCB, disposing a first component and a second component on the FPCB, and disposing a through groove in a position of the second component on the FPCB, where the through groove is configured to enable the FPCB to provide a deformation space when the second component and the first component are positioned on an upper substrate;
providing an upper substrate, where a through hole for assembling and fastening the second component is disposed on the upper substrate; positioning and fastening the first component to the upper substrate, and assembling and fastening the second component to the through hole by deforming the FPCB by using the through groove;
providing a middle frame, positioning and fastening the middle frame to the upper substrate, and injecting adhesive into the middle frame; and
providing a lower substrate, positioning and fastening the lower substrate to the middle frame, and performing lamination and blanking to obtain the smart card.

Preferably, the step of disposing a through groove in a position of the second component on the FPCB includes:
disposing the through groove around the second component with the two ends disconnected.

Preferably, the step of disposing the through groove around the second component with the two ends disconnected includes:
providing the second component with a first side facing the first component, two second sides adjacent to the first side, and a third side opposite to the first side;
disposing the through groove around the first side and the two second sides of the second component, so that a mounting area, for the second component, connected on the third side to the other part of the FPCB is formed on the FPCB; and disposing the second component in the mounting area for the second component; and
extending the two ends of the through groove toward each other, so that the two ends of the through groove are located on the third side of the second component.

Preferably, the first component and the second component are components visible on a surface of the smart card, the first component is a display screen, and the second component is a carrier tape unit.

### BENEFICIAL EFFECT

In the technical solutions provided in the present invention, the through groove is disposed on the FPCB, and the through groove divides the FPCB into a first area, inside the through groove, for disposing the second component, a second area outside the through groove, and a third area connecting the first area and the second area. If an error occurs in a position between the second component and the first component in the production process, the third area can be deformed. The deformation is used to adjust the second component in the first area to a correct position relative to the first component, so that the two components are positioned and fastened to correct positions on the smart card, thereby avoiding a defective appearance or function of the smart card caused by displacement of the two positions of the two components that is resulted from the production processing error, and further ensuring that components on the smart card meet appearance and function requirements and increasing a production yield rate of the smart card.

### BRIEF DESCRIPTION OF DRAWINGS

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art can derive other drawings from the structures illustrated in these accompanying drawings without creative efforts.
FIG. 1 is a schematic structural diagram of an FPCB according to the present invention;
FIG. 2 is a schematic structural diagram of a first component and a second component soldered on the FPCB shown in FIG. 1;
FIG. 3 is a schematic structural diagram of a smart card obtained after lamination and blanking according to the present invention;
FIG. 4 is a schematic sectional view of the smart card in FIG. 3;
FIG. 5 is a schematic rear view of an upper substrate obtained before the smart card in FIG. 3 is laminated;
FIG. 6 is a schematic structural diagram in which the FPCB in FIG. 2 is positioned and fastened to the back of the upper substrate in FIG. 5; and
FIG. 7 is a schematic structural diagram of a middle frame that is positioned and fastened to the back of the upper substrate in FIG. 6.

### Explanation of reference numerals:

| Numeral | Name | Numeral | Name |
|---|---|---|---|
| 100 | Smart card | 42 | Mounting area for a display screen |
| 1 | Upper substrate | 43 | Mounting area for a carrier tape unit |
| 11 | Positioning frame | 5 | First component |
| 12 | Through hole | 5a | Display screen |
| 2 | Lower substrate | 6 | Second component |
| 3 | Middle frame | 6a | Carrier tape unit |
| 4 | FPCB | 7 | Interior receiving cavity |
| 41 | Through groove | | |

Objective attainment, function features, and advantages of the present invention are further described with reference to the embodiments and the accompanying drawings.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

It should be noted that, if there are directional indications (such as upper, lower, left, right, front, and back) in the embodiments of the present invention, the directional indications are merely used to explain relative position relationships, motion statuses, and the like between components in a specific posture (as shown in the accompanying drawings). If the specific posture changes, the directional indications change accordingly.

In addition, if descriptions related to "first", "second", and the like are provided in the embodiments of the present invention, the descriptions of "first", "second", and the like are used only for description purposes, and cannot be understood as indicating or implying relative importance thereof or implicitly indicating the quantity of indicated technical features. Therefore, a feature limited by "first" or "second" can explicitly or implicitly include at least one of the features. In addition, the technical solutions between the embodiments can be combined with each other. However, such combination should be based on implementation by a person of ordinary skill in the art. When a technical solution combination is contradictory or cannot be implemented, it should be considered that this technical solution combination neither exists nor falls within the protection scope contemplated by the present invention.

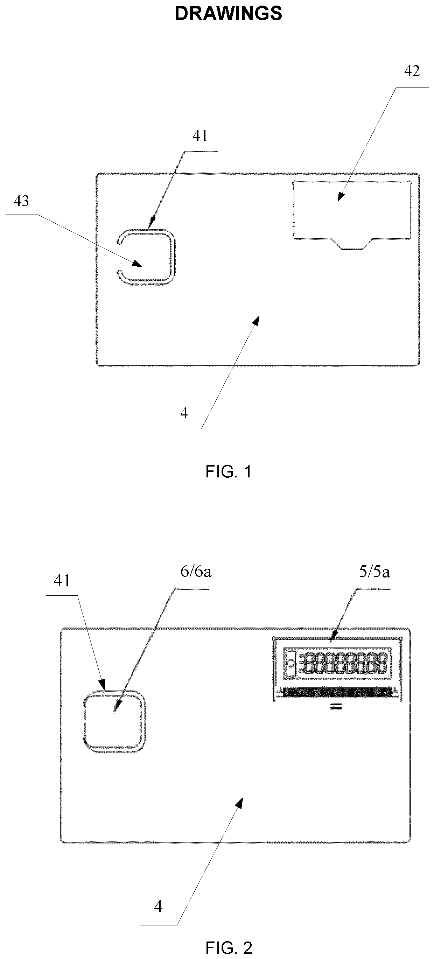

The present invention provides an FPCB, which is applied to a smart card. FIG. 1 and FIG. 2 show an embodiment of the FPCB according to the present invention. The smart card includes an upper substrate.

Referring to FIG. 1 and FIG. 2, a first component 5 and a second component 6 are disposed on the FPCB 4, and a through groove 41 is disposed on the FPCB 4 in a position of the second component 6, where the through groove 41 is configured to enable the FPCB 4 to provide a deformation space when the second component 6 and the first component 5 are positioned on the upper substrate 1.

In the technical solutions provided in the present invention, the through groove 41 is disposed on the FPCB 4, and the through groove 41 divides the FPCB 4 into a first area, inside the through groove 41, for disposing the second component 6, a second area outside the through groove 41, and a third area connecting the first area and the second area. If an error occurs in a position between the second component 6 and the first component 5 during production, the third area can be deformed. As such, the deformation is used to adjust the second component 6 in the first area to a correct position relative to the first component 5, so that the two components are positioned and fastened to correct positions on the smart card, thereby avoiding a defective appearance or function of the smart card caused by displacement of the two positions of the two components that is resulted from the production processing error, and further ensuring that components on the smart card meet appearance and function requirements and increasing a production yield rate of the smart card.

There can be multiple dispositions for a specific structure of the through groove 41, provided that a part of the FPCB 4 located near the position of the second component 6 can be deformed, so that the second component 6 is positioned and fastened to a correct position relative to the first component 5. No limitation is imposed herein. Specifically, in this embodiment, referring to FIG. 1, the through groove 41 is disposed around the second component 6 with the two ends disconnected. In this disposition, only one side (that is, the third area of the FPCB 4) of the through groove 41 is reserved to facilitate cabling and electrical connection. The FPCB area for cabling on this side needs to be as narrow as possible, so that the part of the FPCB 4 located near the position of the second component 6 is well deformed, to adjust the processing error between the second component 6 and the first component 5.

Further, more specifically, the second component 6 is provided with a first side facing the first component 5, two second sides adjacent to the first side, and a third side opposite to the first side. The through groove 41 is disposed around the first side and the two second sides of the second component 6, so that a mounting area, for the second component 6, connected on the third side to the other part of the FPCB 4 is formed on the FPCB 4. The second component 6 is disposed in the mounting area for the second component 6. The two ends of the through groove 41 extend toward each other, so that the two ends of the through groove 41 are located on the third side of the second component.

In this disposition, the through groove 41 surrounds most peripheral edges of the second component 6, so as to form, on the FPCB 4, the first area, inside the through groove 41, for disposing the second component 6, the second area outside the through groove 41, and the third area, reserved on the third side of the second component 6, for connecting the first area and the second area, to facilitate cabling and connection between the second component 6 and an electronic module of the smart card 100.

Further, the two ends of the through groove 41 extend toward each other, so that the third area on the FPCB 4 is as narrow as possible and easily deformed. As such, the processing error between the second component 6 and the first component 5 is easily adjusted, and the second component 6 is positioned and fastened to a correct position relative to the first component 5. Certainly, the through groove 41 can be further disposed in another structure, provided that the FPCB 4 in the position of the carrier tape unit 6a can be deformed, so that the carrier tape unit 6a is positioned in a predetermined position. No limitation is imposed herein.

The first component 5 and the second component 6 can be internal components of the smart card 100, or components visible on a surface of the smart card 100. Specifically, in this embodiment, the first component 5 and the second component 6 are components visible on the surface of the smart card 100.

Further, more specifically, the first component 5 is a display screen 5a, and the second component 6 is a carrier tape unit 6a. The smart card 100 generally has the electronic display screen 5a and the carrier tape unit 6a. The electronic display screen 5a and the carrier tape unit 6a are disposed on the FPCB 4, and relative positions of the carrier tape unit 6a and the display screen 5a are fixed. If displacement occurs in the two positions, the entire card is scrapped due to impact on its appearance. However, in the actual production process, the carrier tape unit 6a and the display screen 5a may encounter a processing error, which causes displacement to the positions of the carrier tape unit 6a and the display screen 5a. The through groove 41 is disposed around the position of the carrier tape unit 6a on the FPCB 4, so that the FPCB 4 is deformed in the third area, on the third side of the carrier tape unit 6a, for connecting the first area and the second area, to adjust the processing error between the carrier tape unit 6a and the display screen 5a, thereby ensuring that the carrier tape unit 6a and the display screen 5a on the smart card meet appearance and function requirements and further increasing a production yield rate of the smart card 100.

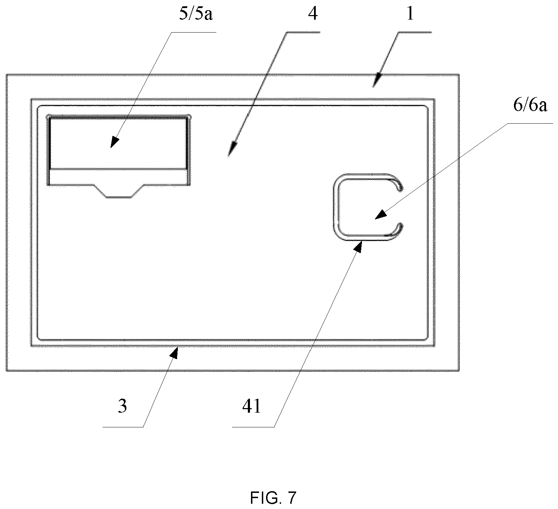

The present invention provides a smart card. FIG. 1 to FIG. 7 show an embodiment of a smart card according to the present invention.

Referring to FIG. 1 to FIG. 7, the smart card 100 includes an FPCB 4, an upper substrate 1, a middle frame 3, and a lower substrate 2. A first component 5 and a second component 6 are disposed on the FPCB 4, and a through groove 41 is disposed on the FPCB 4 in a position of the second component 6. The through groove 41 is configured to enable the FPCB 4 to provide a deformation space when the second component 6 and the first component 5 are positioned on the upper substrate 1. A through hole 12 for assembling and fastening the second component 6 is disposed on the upper substrate 1. The lower substrate 2 is disposed below the upper substrate 1. The middle frame 3 is sandwiched between the upper substrate 1 and the lower substrate 2, and surrounds and forms an interior receiving cavity 7 jointly with the upper substrate 1 and the lower substrate 2. The interior receiving cavity 7 is configured to accommodate the FPCB 4.

Further, the through groove 41 is disposed around the second component 6 with the two ends disconnected. The first component 5 and the second component 6 are components visible on a surface of the smart card. In this embodiment, the smart card 100 is a visual smart card, where the first component 5 is a display screen 5a, and the second component 6 is a carrier tape unit 6a. The upper substrate 1 is further provided with a transparent window corresponding to the display screen 5a, so as to produce a visual smart card.

In the technical solutions provided in the present invention, the through groove 41 is disposed on the FPCB 4, and the through groove 41 divides the FPCB 4 into a first area, inside the through groove 41, for disposing the second component 6, a second area outside the through groove 41, and a third area connecting the first area and the second area. If an error occurs in a position between the second component 6 and the first component 5 during production, the third area can be deformed. As such, the deformation is used to adjust the processing error between the two components, so that the second component 6 in the first area is adjusted to a correct position relative to the first component 5. In this embodiment, the second component 6 is correctly assembled and fastened to the through hole 12 on the upper substrate 1, thereby avoiding a defective appearance or function caused by displacement of the two positions of the two components that is resulted from the production processing error, and further ensuring that components on the smart card meet appearance and function requirements and increasing a production yield rate of the smart card 100.

The present invention further provides a smart card packaging method. FIG. 1 to FIG. 7 show an embodiment of the smart card packaging method according to the present invention. The smart card packaging method includes the following steps:
providing an FPCB 4, disposing a first component 5 and a second component 6 on the FPCB 4, and disposing a through groove 41 in a position of the second component 6 on the FPCB 4, where the through groove 41 is configured to enable the FPCB 4 to provide a deformation space when the second component 6 and the first component 5 are positioned on an upper substrate;
providing an upper substrate 1, where a through hole 12 for assembling and fastening the second component 6 is disposed on the upper substrate 1; positioning and fastening the first component 5 to the upper substrate 1, and assembling and fastening the second component 6 to the through hole 12 by deforming the FPCB 4 by using the through groove 41;
providing a middle frame 3, positioning and fastening the middle frame 3 to the upper substrate 1, and injecting adhesive into the middle frame 3; and
providing a lower substrate 2, positioning and fastening the lower substrate 2 to the middle frame 3, and performing lamination and blanking to obtain the smart card 100.

In this embodiment, referring to FIG. 1 and FIG. 2, the through groove 41 is disposed on the FPCB 4, and the through groove 41 divides the FPCB 4 into a first area, inside the through groove 41, for disposing the second component 6, a second area outside the through groove 41, and a third area connecting the first area and the second area. If an error occurs in a position between the second component 6 and the first component 5 during production, the third area can be deformed. As such, the deformation is used to adjust the processing error between the two components, so that the second component 6 in the first area is adjusted to a correct position relative to the first component 5, to position and fasten the two components, thereby avoiding a defective appearance or function of the smart card caused by displacement of the two positions of the two components that is resulted from the production processing error, and further ensuring that components on the smart card meet appearance and function requirements and increasing a production yield rate of the smart card.

There can be multiple dispositions for a specific structure of the through groove 41, provided that a part of the FPCB 4 located near the position of the second component 6 can be deformed, so that the second component 6 is positioned and fastened to a correct position relative to the first component 5. No limitation is imposed herein. Specifically, in this embodiment, referring to FIG. 1 and FIG. 2, the step of disposing a through groove 41 in a position of the second component 6 on the FPCB 4 includes: disposing the through groove 41 around the second component 6 with the two ends disconnected.

Further, the second component 6 is provided with a first side facing the first component 5, two second sides adjacent to the first side, and a third side opposite to the first side. The through groove 41 is disposed around the first side and the two second sides of the second component 6, so that a mounting area, for the second component 6, connected on the third side to the other part of the FPCB 4 is formed on the FPCB 4. The second component 6 is disposed in the mounting area for the second component 6. The two ends of the through groove 41 extend toward each other, so that the two ends of the through groove 41 are located on the third side of the second component 6.

This structural disposition of the through groove 41 enables the through groove 41 to surround most peripheral edges of the second component 6, so as to form, on the FPCB 4, the first area, inside the through groove 41, for disposing the second component 6, the second area outside the through groove 41, and the third area, reserved on the third side of the second component 6, for connecting the first area and the second area, to facilitate cabling and connection between the second component 6 and an electronic module of the smart card 100.

Further, the two ends of the through groove 41 extend toward each other, so that the third area on the FPCB 4 is as narrow as possible and easily deformed. As such, the processing error between the second component 6 and the first component 5 is easily adjusted, and the second component 6 is positioned and fastened to a correct position relative to the first component 5. Certainly, the through groove 41 can be further disposed in another structure, provided that the FPCB 4 in the position of the carrier tape unit 6a can be deformed, so that the carrier tape unit 6a is positioned in a predetermined position. No limitation is imposed herein.

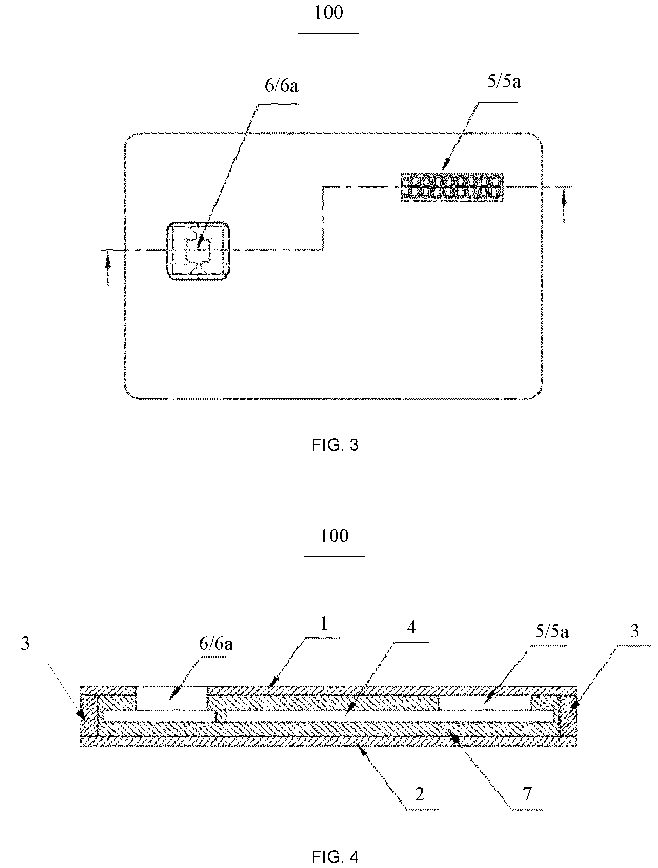

The first component 5 and the second component 6 can be internal components of the smart card 100, or components visible on a surface of the smart card 100. In this embodiment, the smart card 100 is a visual smart card. The visual smart card 100 is generally provided with an electronic display screen 5a and a carrier tape unit 6a. Relative positions of the carrier tape unit 6a and the display screen 5a are fixed. A transparent window (not shown in the figure) is disposed in a position, on the upper substrate 1, corresponding to the display screen. A positioning frame for positioning and fastening the display screen 5a is silk-screened in the transparent window on the back of the upper substrate 1. In this embodiment, referring to FIG. 3, the first component 5 and the second component 6 are components visible on a surface of the smart card 100, the first component 5 is the display screen 5a, and the second component 6 is the carrier tape unit 6a.

The step of disposing a first component 5 and a second component 6 on the FPCB 4 includes: providing the FPCB 4 with a mounting area 42 for the display screen and a mounting area 43 for the carrier tape unit, as shown in FIG. 1 and FIG. 2. There are multiple specific connection manners for disposing the display screen 5a and the carrier tape unit 6a respectively in the mounting area 42 for the display screen and the mounting area 43 for the carrier tape unit. No limitation is imposed herein.

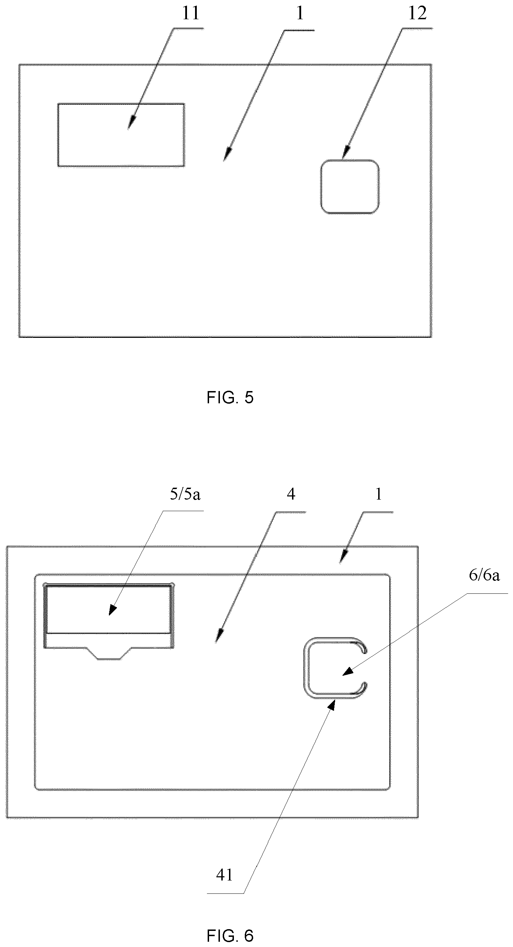

The step of positioning and fastening the first component 5 to a lower surface of the upper substrate 1, and assembling and fastening the second component 6 to the through hole 12 by deforming the FPCB 4 by using the through groove 41 includes: as shown in FIG. 5 and FIG. 6, disposing a transparent window (not shown in the figure) on the upper substrate 1 corresponding to the display screen, silk-screening a positioning frame 11 for positioning and fastening the display screen 5a in the corresponding transparent window on the back of the upper substrate 1, printing a layer of adhesive on the back of the upper substrate 1 to identify the position of the display screen 5a, and positioning and fastening the display screen 5a to the positioning frame 11; and providing the upper substrate 1 with a through hole 12 for assembling and fastening the carrier tape unit 6a, to identify the position of the carrier tape unit 6a, and assembling and fastening the carrier tape unit 6a to the through hole 12 by deforming the FPCB 4 by using the through groove 41, so that the display screen 5a and the carrier tape unit 6a on the FPCB 4 are assembled and fastened to the upper substrate 1.

It should be noted that a sequence of the step of providing the FPCB 4 and the step of providing the upper substrate 1 is not limited, and the upper substrate 1 may be first provided, or the FPCB 4 may be first provided, which is not limited herein.

Similarly, a sequence of the step of disposing the positioning frame 11 of the display screen 5a and the step of disposing the through hole 12 of the carrier tape unit 6a is not limited. The positioning frame 11 of the display screen 5a may be first disposed, or the through hole 12 of the carrier tape unit 6a may be first disposed, which is not limited herein.

Specific operation steps of packaging the smart card 100 are as follows: referring to FIG. 1 to FIG. 7, the display screen 5a and the carrier tape unit 6a are disposed on the FPCB 4, and the through groove 41 is disposed in the position of the carrier tape unit 6a on the FPCB 4; the positioning frame 11 for positioning and fastening the display screen 5a is silk-screened on the back of the upper substrate 1, the through hole 12 for assembling and fastening the carrier tape unit 6a is disposed on the upper substrate 1, the display screen 5a is positioned and fastened to the positioning frame 11, and the carrier tape unit 6a is assembled and fastened to the through hole 12 by deforming the FPCB 4 by using the through groove 41; the FPCB 4 on which the display screen 5a and the carrier tape unit 6a are disposed is assembled and fastened to the upper substrate 1; then, the middle frame 3 is positioned and fastened to the upper substrate 1, and adhesive is injected into the middle frame 3; the lower substrate 2 is positioned and fastened to the middle frame 3, and lamination and blanking are performed to obtain the smart card 100, so as to complete packaging of the smart card 100.

The foregoing descriptions are merely example embodiments of the present invention, and the protection scope of the present invention is not limited thereto. All equivalent structure changes made according to the content of this specification and accompanying drawings in the present invention or by directly or indirectly applying the present invention in other related technical fields without departing from the inventive concept of the present invention shall fall within the protection scope of the present invention.

## Claims

1. An FPCB, applied to a smart card, the smart card comprising an upper substrate, wherein a first component and a second component are disposed on the FPCB, and a through groove is disposed on the FPCB in a position of the second component, wherein the through groove is configured to enable the FPCB to provide a deformation space when the second component and the first component are positioned on the upper substrate.

2. The FPCB according to claim 1, wherein the through groove is disposed around the second component with the two ends disconnected.

3. The FPCB according to claim 2, wherein the second component has a first side facing the first component, two second sides adjacent to the first side, and a third side opposite to the first side;
the through groove is disposed around the first side and the two second sides of the second component, so that a mounting area, for the second component, connected on the third side to the other part of the FPCB is formed on the FPCB, and the second component is disposed in the mounting area for the second component; and
the two ends of the through groove extend toward each other, so that the two ends of the through groove are located on the third side of the second component.

4. The FPCB according to claim 1, wherein the first component and the second component are components visible on a surface of the smart card.

5. The FPCB according to claim 1, wherein the first component is a display screen, and the second component is a carrier tape unit.

6. A smart card, comprising:
the FPCB according to any one of claims 1 to 5;
an upper substrate, wherein a through hole for assembling and fastening the second component is disposed on the upper substrate;
a lower substrate, disposed below the upper substrate; and
a middle frame, sandwiched between the upper substrate and the lower substrate, configured to surround and form an interior receiving cavity jointly with the upper substrate and the lower substrate, wherein the interior receiving cavity is configured to accommodate the FPCB.

7. A smart card packaging method, comprising the following steps:
providing an FPCB, disposing a first component and a second component on the FPCB, and disposing a through groove in a position of the second component on the FPCB, wherein the through groove is configured to enable the FPCB to provide a deformation space when the second component and the first component are positioned;
providing an upper substrate, wherein a through hole for assembling and fastening the second component is disposed on the upper substrate; positioning and fastening the first component to the upper substrate, and assembling and fastening the second component to the through hole by deforming the FPCB by using the through groove;
providing a middle frame, positioning and fastening the middle frame and the FPCB to the upper substrate, and injecting adhesive into the middle frame; and
providing a lower substrate, positioning and fastening the lower substrate to the middle frame, and performing lamination and blanking to obtain the smart card.

8. The smart card packaging method according to claim 7, wherein the step of disposing a through groove in a position of the second component on the FPCB comprises:
disposing the through groove around the second component with the two ends disconnected.

9. The smart card packaging method according to claim 8, wherein the step of disposing the through groove around the second component with the two ends disconnected comprises:
providing the second component with a first side facing the first component, two second sides adjacent to the first side, and a third side opposite to the first side;
disposing the through groove around the first side and the two second sides of the second component, so that a mounting area, for the second component, connected on the third side to the other part of the FPCB is formed on the FPCB; and disposing the second component in the mounting area for the second component; and
extending the two ends of the through groove toward each other, so that the two ends of the through groove are located on the third side of the second component.

10. The smart card packaging method according to claim 7, wherein the first component and the second component are components visible on a surface of the smart card, the first component is a display screen, and the second component is a carrier tape unit.
